# EUROPEAN PATENT SPECIFICATION

(11) **EP 0 361 963 B1**
(45) Date of publication and mention of the grant of the patent: **03.08.1994**
(21) Application number: 89309988.7
(22) Date of filing: 29.09.1989
(51) Int. Cl.: C04B 35/00, H01L 39/12, H01L 39/24

(54) **R-T1-Sr-Ca-Cu-O superconductors and processes for their preparation**
Metall-Thallium-Strontium-Calcium-Kupfer-Sauerstoff-Supraleiter und Verfahren zu ihrer Herstellung
Supraconducteurs du type métal-thallium-strontium-calcium-cuivre-oxygène et procédés pour leur fabrication

(30) Priority: 29.09.1988 US 251348
(43) Date of publication of application: 04.04.1990
(73) Proprietor: UNIVERSITY OF ARKANSAS, Fayetteville, Arkansas 72701 (US)
(72) Inventor: Hermann, Allen M., Dr., Fayetteville Arkansas 72702 (US); Sheng, Zhengzhi, Dr., Fayetteville Arkansas 72701 (US)
(74) Representative: Sheard, Andrew Gregory

(56) References cited:
- EP-A- 0 283 620
- PHYSICAL REVIEW B, vol. 39, no. 4, 1st February 1989, pages 2918-2920, The American Physical Society; Z.Z. SHENG et al.: "Superconductivity above 77 K in the R-Tl-Sr-Ca-Cu-O system (R represents rare earths)
- PHYSICAL REVIEW B, vol. 40, no. 4, 1st August 1989, pages 2565-2567, The American Physical Society; C.N.R. RAO et al.: "Superconducting (1:1:2:2)-type layered cuprates of the formula TlCa1-xLxSr2Cu2Oy (L = Y or a rate-earth element)

## Description

The present invention relates generally to high temperature superconductors. More specifically, the present invention relates to a new high temperature superconductor system and processes for making same.

A variety of superconducting systems are known. The inventors of the present patent application have filed the following patent applications that disclose superconductors and/or methods of making same.

European patent applications EP-A-0324660 and EP-A-0324661 disclose a high temperature superconductor having the composition Tl-R-X-Y wherein: R is an element chosen from Group 2A; X is an element chosen from Group 1B; and Y is an element chosen from Group 6B, and a high temperature superconductor having the composition: Tl-R-Ba-Cu-O wherein R is a Group 2A element excluding barium; or Tl-Sr-Cu-O. In an embodiment, R is either strontium or calcium.

European patent application EP-A-0302733 discloses a high temperature superconductor having the composition: Tb-R-Ba-Cu-O wherein R is chosen from the group of rare earth metals excluding: praseodymium; cerium; and terbium.

European patent application EP-A-0305179 discloses a high temperature superconductor having the composition: R-Ba-Cu-O wherein R is chosen from the group of rare earth metals excluding: praseodymium; terbium; and cerium.

European patent application no. 89308574.6 discloses a process for making Tl-Ba-Ca-Cu-O superconductors.

Applicants has also filed, on 29th September 1988, a patent application entitled: "Tl-Sr-Ca-Cu-O SUPERCONDUCTORS AND PROCESSES FOR MAKING SAME". The patent application discloses a high temperature superconductor having the formula Tl-Sr-Ca-Cu-O and processes for making same.

A new superconductor would be desirable for many reasons. Such a superconductor would: (1) facilitate the discovery of the correct theory on oxide superconductivity; (2) provide a framework for the search for higher temperature, even room temperature superconductors; (3) allow superconducting components to operate with lower cost; and (4) provide low cost processing and manufacturability. Furthermore, in superconducting systems including Tl, there is a drawback in that Tl is toxic. Therefore, a superconducting system with a reduced amount of Tl would be desirable.

Accordingly, there is a need for new higher temperature superconductors.

The present invention provides a new superconductor system that yields a number of new high temperature superconductors with transition temperatures above liquid nitrogen temperature that are unique to date among all high temperature conductors. Methods for producing the high temperature superconductors of the present invention are also provided. The methods allow the superconductors to be prepared at temperatures of approximately 850 to about 1000°C in flowing oxygen.

Accordingly, an advantage of the present invention is to provide a number of new superconducting systems having high transition temperatures.

A further advantage of the present invention is to provide a number of material systems that may produce higher temperature, even room temperature superconductors.

A still further advantage of the present advantage is that it provides a number of new high temperature superconductors that can be rapidly fabricated.

Furthermore, an advantage of the present invention is that it provides processes for making new high temperature superconductors.

Still another advantage of the present invention is that it provides processes for rapidly making high temperature superconductors.

According to a first aspect of the present invention there is provided a compound of the general formula:

MTlₓSr_{y}Ca_{z}CuᵤOᵥ

wherein:
M represents La, Pr, Nd, Sm, Eu, Gd, Tb, Dy, Ho, Er, Tm, Yb, Lu, or Y;
x is greater than 0.1 and less than 10;
y is greater than zero and less than or equal to 10;
z is greater than zero and less than or equal to 10;
y+z is greater than 0.1 and less than 20;
u is greater than 0.5 and less than 20; and
v is greater than x+y+z+u and less than 5+x+y+z+u.

Thus the present invention provides new superconductor compounds with phases whose transition temperatures are above liquid nitrogen temperature. The present invention also provides a number of new material systems that may produce higher temperature, even room temperature superconductors by further elemental substitution and variation of preparation procedures.

The inventors of the present invention have found that superconductors having this formula are superconducting above liquid nitrogen temperature. To date, the following above-liquid-nitrogen-temperature superconducting systems are known: rare earth-Ba-Cu-O (90K); Tl-Ba-Cu-O (90K); Bi-Sr-Ca-Cu-O (110K); and Tl-Ba-Ca-Cu-O (120K). The compounds of the present invention and in particular M-Tl-Sr-Ca-Cu-O are the fifth above-liquid-nitrogen-temperature superconducting systems.

The present invention may thus provide a number of new superconductors that can be operated at higher temperature at lower cost. Furthermore, the new high temperature superconductors of the present invention may be rapidly produced.

In one embodiment, the superconductor compounds of the present invention have the following general formula:

Pr-Tl-Sr-Ca-Cu-O.

In another embodiment, the superconductor compounds of the present invention have the following general formula:

Tb-Tl-Sr-Ca-Cu-O.

Preferred compounds have the following approximate molar ratios:
a) M:Tl:Sr:Ca:Cu is about 1:2:2:2:3; or
b) M:Tl:Sr:Ca:Cu is about 1:1:2:4:5.

According to a second aspect of the present invention there is provided a process for the preparation of a compound of the first aspect, the process comprising admixing compounds of the elements M, Tl, Sr, Ca, and Cu and heating where necessary.

Preferred starting compounds may include any or all of the following:
a) an oxide of M;
b) an oxide of Tl;
c) an oxide, but preferably a carbonate, of Sr;
d) an oxide, but preferably a carbonate, of Ca; and
e) an oxide of Cu.

These starting compounds are preferably provided in amounts such that the molar ratio M:Tl:Sr:Ca:Cu is about either 1:2:2:2:3 or about 1:1:2:4:5.

A preferred process comprises:
1) admixing starting compounds (c), (d) and (e);
2) heating the mixture;
3) mixing the resultant compound with starting compound (a), and optionally (b);
4) heating the mixture; and
5) where necessary, contacting the mixture with (b) and heating.

In (1), the starting compounds are preferably mixed in the molar ratio (c):(d):(e) of either about 2:2:3 or 2:4:5. The mixing preferably includes grinding.

In (2), the heating is preferably at a temperature of from 900-1000°C, for example 950°C, suitably in air. This is advantageously carried out for at least 24 hours. The resultant compound is suitably cooled and ground, and preferably has a nominal composition Sr₂Ca₂Cu₃O₇ or Sr₂Ca₄Cu₅O₁₁.

With (3), mixing may include grinding the mixture before pressing the ground mixture into a pellet. Where (b) is added, the ratio of M:Tl:Sr:Ca:Cu is preferably either about 1:2:2:2:3 or about 1:1:2:4:5.

In (4), heating is preferably to a temperature of from 850-1000°C, suitably 900-950°C, for example in flowing oxygen. This is carried out for up to 10 minutes, such as 2-3 minutes and the mixture cooled.

In (5), this method is particularly suitable for producing the 1:2:2:2:3 compounds containing thallium. Contact with (b) is preferably by heating (b) to a vapour state, so contacting the previously heated mixture which is preferably in the form of a pellet. The amount of (b) is suitably 0.1 - 0.2g, with heating at from 850-950°C, eg. 900°C, and preferably in flowing oxygen, for example for 2-5 minutes.

After heating in (4) or (5), the compound may be annealed in flowing oxygen.

Particularly preferred preparation processes are as follows.
A. A process comprising:
   a. gringing a mixture of SrCO₃, CaCO₃, and CuO;
   b. heating the mixture;
   c. cooling the heated mixture so that a nominal Sr₂Ca₂Cu₃O₇ mixture is obtained;
   d. grinding a mixture of a rare earth oxide, Tl₂O₃, and Sr₂Ca₂Cu₃O₇ pressing the mixture into a pellet;
   e. heating the pellet; and
   f. cooling the pellet to room temperature.

   Preferably the pellet after (e) is put in a platinum boat, and the boat is heated in flowing oxygen, and/or the pellet in step (c) is heated in flowing oxygen. The pellet of (f) is usually quenched in air to room temperature, and suitably the rare earth oxide is chosen from the group consisting of La₂O₃, Pr₂O₃, Nd₂O₃, Sm₂O₃, Eu₂O₃, Gd₂O₃, Tb₄O₇, Dy₂O₃, Ho₂O₃, Er₂O₃, Tm₂O₃, Yb₂O₃, Lu₂O₃, and Y₂O₃.
   The mixture of SrCO₃, CaCO₃ and CuO will preferably have a molar ratio of about 2:2:3, so that with the combination of rare earth oxide Tl₂O₃, and Sr₂Ca₂Cu₃O₇, the atomic molar ratio is 1:2:2:2:3 (M:Tl:Sr:Ca:Cu).
B. A process comprising:
   a. grinding a mixture of SrCO₃, CaCO₃, and CuO;
   b. heating the mixture;
   c. cooling and grinding the mixture so that a powder with a nominal composition of Sr₂Ca₂Cu₃O₇ is obtained;
   d. grinding a mixture of a rare earth oxide and Sr₂Ca₂Cu₃O₇ and pressing the ground mixture into a pellet;
   e. heating the pellet;
   f. heating the pellet with an amount of Tl₂O₃; and
   g. cooling the heated pellet to room temperature.

   Suitably the Tl₂O₃, prior to being heated in step (f), is placed in a platinium boat which is put in a quartz boat, and the pellet of (e) is put over the platinium boat.
   The mixture of SrCO₃, CaCO₃ and CuO preferably has a molar ratio of 2:2:3, so that the mixture of rare earth oxide and Sr₂Ca₂Cu₃O₇ ground in step (d) has an atomic molar ration of 1:2:2:3 (R:Sr:Ca:Cu).
   In step (b) the mixture is advantageously heated at 950°C in air, and in step (e), the pellet may be heated at 950°C in air or flowing oxygen.
   Preferably between approximately 0.1 to about 0.2 grams of Tl₂O₃ is heated to form Tl₂O₃ vapor that reacts with the pellet, and in step (f) the pellet and Tl₂O₃ is suitably heated to 950°C in flowing oxygen.
   The rare earth oxide is preferably La₂O₃, Pr₂O₃, Nd₂O₃, Sm₂O₃, Eu₂O₃, Gd₂O₃, Tb₄O₇, Dy₂O₃, Ho₂O₃, Er₂O₃, Tm₂O₃, Yb₂O₃, Lu₂O₃, or Y₂O₃.
C. A process comprising:
   a. grinding a mixture of SrCO₃, CaCO₃, and CuO;
   b. heating the ground mixture;
   c. cooling and then grinding the mixture to produce a powder;
   d. grinding a mixture of rare earth oxide, Tl₂O₃, and the powder of (c) and pressing the ground mixture into a pellet;
   e. heating the pellet; and
   f. cooling the pellet.

   The pellet may be placed in a platinium boat prior to being heated, and the mixture of SrCO₃, CaCO₃, and CuO preferably has a molar ratio of 2:2:3 such that the powder has the nominal composition Sr₂Ca₂Cu₃O₇.
   Thus the mixture of rare earth oxide, Tl₂O₃, and Sr₂Ca₂Cu₃O₇ may have an atomic molar ratio of 1:2:2:2:3 (R:Tl:Sr:Ca:Cu).
   Alternatively the powder of (c) may have the nominal composition of Sr₂Ca₄Cu₅O₁₁, so that the mixture of rare earth oxide, Tl₂O₃, and Sr₂Ca₄Cu₅O₁₁ has an atomic molar ratio of 1:1:2:4:5 (R:Tl:Sr:Ca:Cu).
   In this case after the pellet is heated in step (e) it is preferably annealed in flowing oxygen.
   Here the mixture of SrCO₃, CaCO₃, and CuO has a molar ratio of 2:4:5.
   Suitably the rare earth oxide is Pr₂O₃ or Tb₄O₇.
   Other features and characteristics of the second aspect of the present invention are as the first, mutatis mutandis.

This invention will now be described by way of example with reference to the accompanying Examples, and also drawings in which:
Figure 1 illustrates graphically ac (5 Khz) resistance versus temperature for nominal RTl₂Sr₂Ca₂Cu₃O₁₂ samples with R = La, Ce, Pr, Nd, Sm, Eu, Gd, Tb, Dy, Ho, Er, Tm, Yb, Lu, and Y.
Figure 2 illustrates graphically dc resistance versus temperature for La-Tl-Sr-Ca-Cu-O, Pr-Tl-Sr-Ca-Cu-O, and Tb-Tl-Sr-Ca-Cu-O samples.
Figure 3 illustrates graphically ac (5 Khz) susceptability versus temperature dependencies for a Pr-Tl-Sr-Ca-Cu-O sample and a Tb-Tl-Sr-Ca-Cu-O sample.

### EXAMPLE 1:

A. The following reagents were utilized:
   1. La₂O₃
   2. Tl₂O₃
   3. SrCO₃
   4. CaCO₃
   5. Cuo
B. The following procedure was followed:
   1. A mixture of SrCO₃, CaCO₃, and CuO with a molar ratio of 2:2:3 was completely ground.
   2. The mixture was heated at 950°C in air for at least 24 hours with several intermediate grindings.
   3. The heated mixture was cooled and ground, so that a powder with a nominal composition of Sr₂Ca₂Cu₃O₇ was obtained.
   4. A mixture of La₂O₃, Tl₂O₃ and Sr₂Ca₂Cu₃O₇ with a molar ratio of 1:2:2:2:3 (La:Tl:Sr:Ca:Cu) was ground and pressed into a pellet.
   5. A tube furnace was heated to 900°C in flowing oxygen.
   6. The pellet was put in a platinium boat, and the boat was placed in a tube furnace, maintaining the temperature and oxygen flow for 3 minutes.
   7. The pellet was then furnace cooled to room temperature.

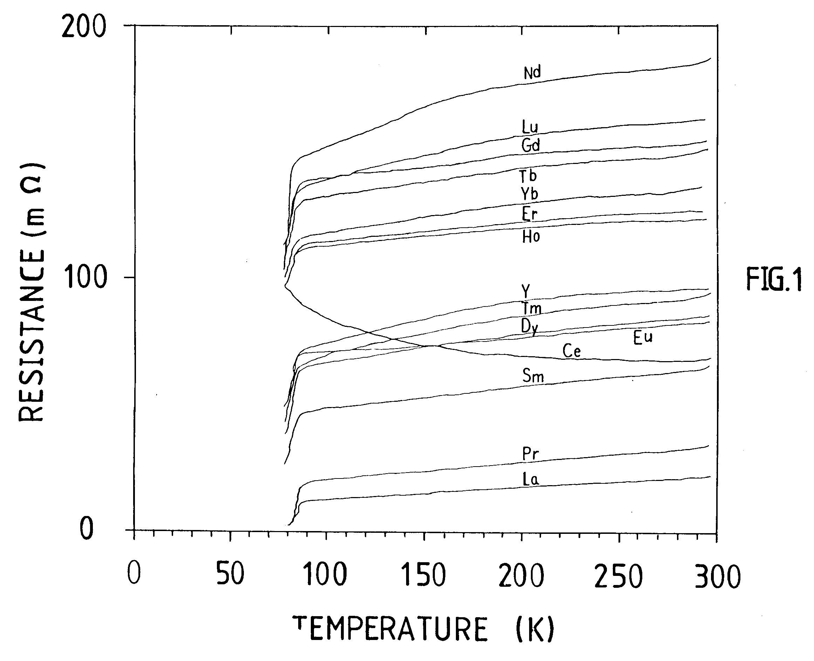

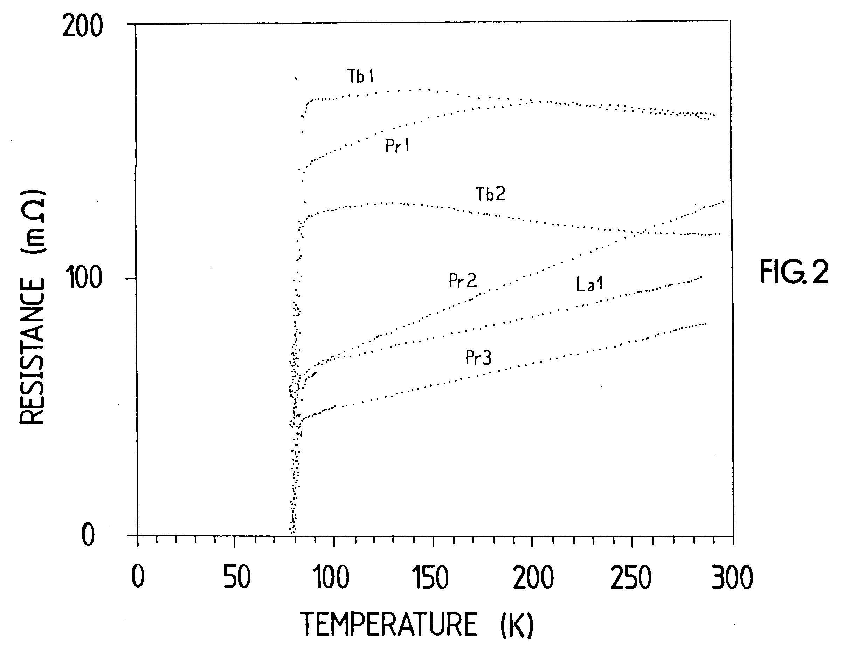

The samples prepared from this procedure were found to be superconducting above liquid nitrogen temperature. The resistance-temperature dependence for a sample prepared pursuant to this example is shown in Figure 1 (curve La) and Figure 2 (curve La1). This sample reached zero resistance at liquid nitrogen temperature.

### EXAMPLE 2:

The procedure was the same as that set forth in Example 1 except that La₂O₃ was replaced by Pr₂O₃.

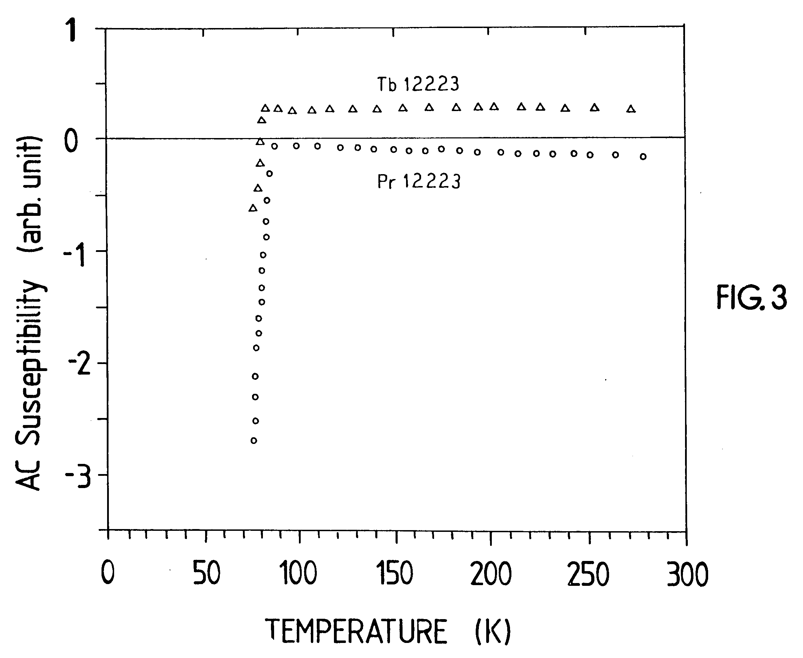

The samples prepared by this procedure were found to be superconducting above liquid nitrogen temperature. The resistance-temperature dependence for a sample prepared pursuant to this example is illustrated in Figure 1 (curve Pr) and Figure 2 (curve Pr3). This sample reached zero resistance at liquid nitrogen temperature. Figure 3 illustrates ac susceptibility-temperature dependence for this sample (curve Pr12223 in Figure 3).

### EXAMPLE 3:

The same procedure as that used in Example 1 was followed except that La₂O₃ was replaced by Nd₂O₃.

The samples prepared by this procedure were found to be superconducting above liquid nitrogen temperature. The resistance-temperature dependence for a sample prepared pursuant to this example is illustrated in Figure 1 (curve Nd).

### EXAMPLE 4:

The same procedure as that set forth in Example 1 was followed except that La₂O₃ was replaced by Sm₂O₃.

The samples prepared by this procedure were found to be superconducting above liquid nitrogen temperature. The resistance-temperature dependence for a sample prepared pursuant to this example is illustrated in Figure 1 (curve Sm).

### EXAMPLE 5:

The same procedure as that set forth in Example 1 was followed except that La₂O₃ was replaced by Eu₂O₃.

The samples prepared by this procedure were found to be superconducting above liquid nitrogen temperature. The resistance temperature dependence for a sample prepared pursuant to this example is illustrated in Figure 1 (curve Eu).

### EXAMPLE 6:

The same procedure as that set forth in Example 1 was followed except that La₂O₃ was replaced by Gd₂O₃.

The samples prepared by this procedure were found to be superconducting above liquid nitrogen temperature. The resistance temperature dependence for a sample prepared pursuant to this example is illustrated in Figure 1 (curve Gd).

### EXAMPLE 7:

The same procedure as that set forth in Example 1 was followed except that La₂O₃ was replaced by Tb₄O₇.

The samples prepared by this procedure were found to be superconducting above liquid nitrogen temperature. The resistance temperature dependence for a sample prepared pursuant to this example is illustrated in Figure 1 (curve Tb). The ac susceptibility-temperature dependence for the sample is illustrated in Figure 3 (curve Tb12223).

### EXAMPLE 8:

The same procedure as that set forth in Example 1 was followed except that La₂O₃ was replaced by Dy₂O₃.

The samples prepared by this procedure were found to be superconducting above liquid nitrogen temperature. The resistance temperature dependence for a sample prepared pursuant to this example is illustrated in Figure 1 (curve Dy).

### EXAMPLE 9:

The same procedure as that set forth in Example 1 was followed except that La₂O₃ was replaced by Ho₂O₃.

The samples prepared by this procedure were found to be superconducting above liquid nitrogen temperature. The resistance temperature dependence for a sample prepared pursuant to this example is illustrated in Figure 1 (curve Ho).

### EXAMPLE 10:

The same procedure as that set forth in Example 1 was followed except that La₂O₃ was replaced by Er₂O₃.

The samples prepared by this procedure were found to be superconducting above liquid nitrogen temperature. The resistance temperature dependence for a sample prepared pursuant to this example is illustrated in Figure 1 (curve Er).

### EXAMPLE 11:

The same procedure as that set forth in Example 1 was followed except that La₂O₃ was replaced by Tm₂O₃.

The samples prepared by this procedure were found to be superconducting above liquid nitrogen temperature. The resistance temperature dependence for a sample prepared pursuant to this example is illustrated in Figure 1 (curve Tm).

### EXAMPLE 12:

The same procedure as that set forth in Example 1 was followed except that La₂O₃ was replaced by Yb₂O₃.

The samples prepared by this procedure were found to be superconducting above liquid nitrogen temperature. The resistance temperature dependence for a sample prepared pursuant to this example is illustrated in Figure 1 (curve Yb).

### EXAMPLE 13:

The same procedure as that set forth in Example 1 was followed except that La₂O₃ was replaced by Lu₂O₃.

The samples prepared by this procedure were found to be superconducting above liquid nitrogen temperature. The resistance temperature dependence for a sample prepared pursuant to this example is illustrated in Figure 1 (curve Lu).

### EXAMPLE 14:

The same procedure as that set forth in Example 1 was followed except that La₂O₃ was replaced by Y₂O₃.

The samples prepared by this procedure were found to be superconducting above liquid nitrogen temperature. The resistance temperature dependence for a sample prepared pursuant to this example is illustrated in Figure 1 (curve Y).

### EXAMPLE 15:

A. The following reagents were utilized:
   1. La₂O₃
   2. Tl₂O₃
   3. SrCO₃
   4. CaCO₃
   5. CuO
B. The following procedure was followed:
   1. A mixture of SrCO₃, CaCO₃, and CuO with a molar ratio of 2:2:3 was completely ground.
   2. The mixture was heated at 950°C in air for at least 24 hours with several intermediate grindings.
   3. The heated mixture was cooled and ground, so that a powder with a nominal composition of Sr₂Ca₂Cu₃O₇ was obtained.
   4. A mixture of La₂O₃ and Sr₂Ca₂Cu₃O₇ with an atomic molar ratio of 1:2:2:3 (La:Sr:Ca:Cu) was ground and pressed into a pellet.
   5. The pellet was heated at 950°C in air or flowing oxygen for 3-10 minutes.
   6. A tube furnace was heated to 900°C in flowing oxygen.
   7. 0.1 to about 0.2 grams of Tl₂O₃ was put in a platinum boat which was put into a quartz boat, and the heated pellet was put over the platinum boat.
   8. The quartz boat and its contents was placed in the tube furnace, maintaining the temperature and oxygen flow for 2 to about 5 minutes.
   9. The quartz boat with its contents was then furnace-cooled to room temperature.

The samples prepared by this procedure were found to be superconducting above liquid nitrogen temperature.

### EXAMPLE 16:

The same procedure as that set forth in Example 15 was followed except that La₂O₃ was replaced by Pr₂O₃.

### EXAMPLE 17:

The same procedure as that set forth in Example 15 was followed except that La₂O₃ was replaced by Nd₂O₃.

### EXAMPLE 18:

The same procedure as that set forth in Example 15 was followed except that La₂O₃ was replaced by Sm₂O₃.

### EXAMPLE 19:

The same procedure as that set forth in Example 15 was followed except that La₂O₃ was replaced by Eu₂O₃.

### EXAMPLE 20:

The same procedure as that set forth in Example 15 was followed except that La₂O₃ was replaced by Gd₂O₃.

### EXAMPLE 21:

The same procedure as that set forth in Example 15 was followed except that La₂O₃ was replaced by Tb₄O₇.

### EXAMPLE 22:

The same procedure as that set forth in Example 15 was followed except that La₂O₃ was replaced by Dy₂O₃.

### EXAMPLE 23:

The same procedure as that set forth in Example 15 was followed except that La₂O₃ was replaced by Ho₂O₃.

### EXAMPLE 24:

The same procedure as that set forth in Example 15 was followed except that La₂O₃ was replaced by Er₂O₃.

### EXAMPLE 25:

The same procedure as that set forth in Example 15 was followed except that La₂O₃ was replaced by Tm₂O₃.

### EXAMPLE 26:

The same procedure as that set forth in Example 15 was followed except that La₂O₃ was replaced by Yb₂O₃.

### EXAMPLE 27:

The same procedure as that set forth in Example 15 was followed except that La₂O₃ was replaced by Lu₂O₃.

### EXAMPLE 28:

The same procedure as that set forth in Example 15 was followed except that La₂O₃ was replaced by Y₂O₃.

### EXAMPLE 29:

A. The following reagents were utilized:
   1. Pr₂O₃
   2. Tl₂O₃
   3. SrCO₃
   4. CaCO₃
   5. CuO
B. The following procedure was followed:
   1. A mixture of SrCO₃, CaCO₃, and CuO with a molar ratio of 2:2:3 was completely ground.
   2. The mixture was heated at 950°C in air for at least 24 hours with several intermediate grindings.
   3. The heated mixture was cooled and ground, ao that a powder with a nominal composition of Sr₂Ca₂Cu₃O₇ was obtained.
   4. A mixture of Pr₂O₃, Tl₂O₃, and Sr₂Ca₂Cu₃O₇ with an atomic molar ratio of 1:2:2:2:3 (Pr:Tl:Sr:Ca:Cu) was ground and pressed into a pellet.
   5. A tube furnace was heated to 950°C in flowing oxygen.
   6. The pellet was put into a platinum boat, and the boat was placed in the tube furnace, maintaining the temperature and oxygen flow for 2 minutes.
   7. The platinum boat with the pellet was then furnace-cooled to room temperature.
      The samples prepared by this procedure were found to be superconducting above liquid nitrogen temperature. The dc resistance-temperature dependence for a sample prepared pursuant to this example is illustrated in Figure 2 (curve Pr2). This sample reached zero resistance at liquid nitrogen temperature.

### EXAMPLE 30:

A. The following reagents were utilized:
   1. Pr₂O₃
   2. Tl₂O₃
   3. SrCO₃
   4. CaCO₃
   5. CuO
B. The following procedure was followed:
   1. A mixture of SrCO₃, CaCO₃, and CuO with a molar ratio of 2:4:5 was completely ground.
   2. The mixture was heated at 950°C in air for at least 24 hours with several intermediate grindings.
   3. The heated mixture was cooled and ground, so that a powder with a nominal composition of Sr₂Ca₄Cu₅O₁₁ was obtained.
   4. A mixture of Pr₂O₃, Tl₂O₃ and Sr₂Ca₄Cu₅O₁₁ with an atomic molar ratio of 1:1:2:4:5 (Pr:Tl:Sr:Ca:Cu) was ground and pressed into a pellet.
   5. A tube furnace was heated to 900°C in flowing oxygen.
   6. The pellet was put in a platinum boat, and the boat was placed in the tube furnace, maintaining the temperature and oxygen flow for 3 minutes.
   7. The pellet was annealed at 710°C in flowing oxygen for 10 hours, followed by furnace-cooling to room temperature.

The sample prepared by this procedure were found to be superconducting above liquid nitrogen temperature. The dc resistance-temperature dependence for a sample prepared pursuant to the method of this example is illustrated in Figure 2 (curve Pr1).

### EXAMPLE 31:

The same procedure as that set forth in Example 30 was followed except that Pr₂O₃ was replaced by Tb₄O₇.

The samples prepared by this procedure were found to be superconducting above liquid nitrogen temperature. The dc resistance-temperature dependence for a sample prepared pursuant to the method of this example is illustrated in Figure 2 (curve Tb2).

### EXAMPLE 32:

A. The following reagents were utilized:
   1. Tb₄O₇
   2. Tl₂O₃
   3. SrCO₃
   4. CaCO₃
   5. CuO
B. The following procedure was followed:
   1. A mixture of SrCO₃, CaCO₃, and CuO with a molar ratio of 2:4:5 was completely ground.
   2. The mixture was heated at 950°C in air for at least 24 hours with several intermediate grindings.
   3. The heated mixture was cooled and ground, so that a powder with a nominal composition of Sr₂Ca₄Cu₅O₁₁ was obtained.
   4. A mixture of Tb₄O₇, Tl₂O₃, and Sr₂Ca₄Cu₅O₁₁ with an atomic molar ratio of 1:1:2:4:5 (Tb:Tl:Sr:Ca:Cu) was ground and pressed into a pellet.
   5. A tube furnace was heated to 950°C in flowing oxygen.
   6. The pellet was put into a platinum boat, and the boat was placed in the tube furnace, maintaining the temperature and oxygen flow for 3 minutes.
   7. The pellet was then quenched in air to room temperature.

The samples prepared by this procedure were found to be superconducting above liquid nitrogen temperature. The dc resistance temperature dependence for a sample prepared pursuant to this method is illustrated in Figure 2 (curve Tb1).

## Claims (Claims for the following Contracting State(s): AT, BE, CH, DE, FR, GB, GR, IT, LI, LU, NL, SE)

1. A compound having the general formula:
MTlₓSr_{y}Ca_{z}CuᵤOᵥ
wherein:
M represents La, Pr, Nd, Sm, Eu, Gd, Tb, Dy, Ho, Er, Tm, Yb, Lu, or Y;
x is greater than 0.1 and less than 10;
y is greater than zero and less than or equal to 10;
z is greater than zero and less than or equal to 10;
y+z is greater than 0.1 and less than 20;
u is greater than 0.5 and less than 20; and
v is greater than x+y+z+u and less than 5+x+y+z+u.

2. A compound as claimed in Claim 1 wherein M represents Pr or Tb.

3. A process for the preparation of a compound of the general formula:
MTlₓSr_{y}Ca_{z}CuᵤOᵥ
wherein:
M represents a rare earth element;
wherein x, y, z, u and v are as defined in claim 1, the process comprising admixing compounds of the elements M, Tl, Sr, Ca, and Cu and heating where necessary.

4. A process as claimed in Claim 3 wherein the compounds are:
a) an oxide of M;
b) an oxide of Tl;
c) an oxide or carbonate of Sr;
d) an oxide or carbonate of Ca; and
e) an oxide of Cu.

5. A process as claimed in Claim 3 or 4 wherein the compounds are mixed in amounts such that the molar ratio M:Tl:Sr:Ca:Cu is either about 1:2:2:2:3 or 1:1:2:4:5.

6. A process as claimed in any of claims 3 to 5 comprising:
1) admixing compounds (c), (d) and (e);
2) heating the mixture;
3) mixing the resultant compound with (a) and optionally (b);
4) heating the mixture; and
5) where necessary, contacting the mixture with (b) and heating.

7. A process according to any of Claims 3 to 6 wherein M represents Pr or Tb.

## Claims (Claims for the following Contracting State(s): ES)

1. A process for the preparation of a compound of the general formula:
MTlₓSr_{y}Ca_{z}CuᵤOᵥ
wherein:
M represents La, Pr, Nd, Sm, Eu, Gd, Tb, Dy, Ho, Er, Tm, Yb, Lu, or Y;
x is greater than 0.1 and less than 10;
y is greater than zero and less than or equal to 10;
z is greater than zero and less than or equal to 10;
y+z is greater than 0.1 and less than 20;
u is greater than 0.5 and less than 20; and
v is greater than x+y+z+u and less than 5+x+y+z+u;
the process comprising admixing compounds of the elements M, Tl, Sr, Ca, and Cu and heating where necessary.

2. A process as claimed in Claim 1 wherein the compounds are:
a) an oxide of M;
b) an oxide of Tl;
c) an oxide or carbonate of Sr;
d) an oxide or carbonate of Ca; and
e) an oxide of Cu.

3. A process as claimed in Claim 1 or 2 wherein the compounds are mixed in amounts such that the molar ratio M:Tl:Sr:Ca:Cu is either about 1:2:2:2:3 or 1:1:2:4:5.

4. A process as claimed in any of Claims 1 to 3 comprising:
1) admixing compounds (c), (d) and (e);
2) heating the mixture;
3) mixing the resultant compound with (a) and optionally (b);
4) heating the mixture; and
5) where necessary, contacting the mixture with (b) and heating.

5. A process as claimed in any of claims 1 to 4 wherein
M represents Pr or Tb.

6. A process as claimed in Claim 4 or 5 wherein in (2) heating is at from 900-1000°C in air for at least 24 hours.

7. A process as claimed in any of Claims 4 to 6 wherein after (2) the resultant compound is of the general formula Sr₂Ca₂Cu₃O₇ or Sr₂Ca₄Cu₅O₁₁.

8. A process as claimed in any of Claims 4 to 7 wherein in (1) the compounds are mixed in the molar ratio (c):(d):(e) of either about 2:2:3 or about 2:4:5.

9. A process as claimed in any of Claims 4 to 8 wherein in (4) heating is from 850-1000°C in flowing oxygen.

## Patentansprüche (Patentansprüche für folgende(n) Vertragsstaat(en): AT, BE, CH, DE, FR, GB, GR, IT, LI, LU, NL, SE)

1. Verbindung der allgemeinen Formel
MTlₓSr_{y}Ca_{z}CuᵤOᵥ
wobei
M die Elemente La, Pr, Nd, Sm, Eu, Gd, Tb, Dy, Ho, Er, Tm, Yb, Lu oder Y darstellt,
x größer als 0,1 und kleiner als 10 ist,
y größer als 0 und kleiner oder gleich 10 ist,
z größer als 0 und kleiner oder gleich 10 ist,
y+z größer als 0,1 und kleiner als 20 ist,
u größer als 0,5 und kleiner als 20 ist und
v größer ist als x+y+z+u und kleiner als 5+x+y+z+u.

2. Verbindung nach Anspruch 1, wobei M das Element Pr oder Tb darstellt.

3. Verfahren zur Herstellung einer Verbindung der allgemeinen Formel
MTlₓSr_{y}Ca_{z}CuᵤOᵥ
wobei
M ein Element der Seltenen Erden ist,
wobei x, y, z, u und v wie in Anspruch 1 definiert sind, welches das Vermischen der Verbindungen der Elemente M, Tl, Sr, Ca und Cu und, falls nötig, Erhitzen umfaßt.

4. Verfahren nach Anspruch 3, wobei die Verbindungen sind:
a) ein Oxid von M,
b) ein Oxid von Tl,
c) ein Oxid oder Carbonat von Sr,
d) ein Oxid oder Carbonat von Ca und
e) ein Oxid von Cu.

5. Verfahren nach Anspruch 3 oder 4, wobei die Verbindungen in solchen Mengen gemischt werden, daß das Molverhältnis M:Tl:Sr:Ca:Cu entweder ungefähr 1:2:2:2:3 oder 1:1:2:4:5 beträgt.

6. Verfahren nach einem der Ansprüche 3 bis 5, welches umfaßt:
1) Vermischen der Verbindungen (c), (d) und (e),
2) Erhitzen der Mischung,
3) Mischen der so entstandenen Verbindung mit (a) und gegebenenfalls (b),
4) Erhitzen der Mischung und,
5) falls nötig, das Zusammenbringen der Mischung mit (b) und Erhitzen.

7. Verfahren nach einem der Ansprüche 3 bis 6, wobei M das Element Pr oder Tb darstellt.

## Patentansprüche (Patentansprüche für folgende(n) Vertragsstaat(en): ES)

1. Verfahren zur Herstellung einer Verbindung der allgemeinen Formel
MTlₓSr_{y}Ca_{z}CuᵤOᵥ
wobei
M die Elemente La, Pr, Nd, Sm, Eu, Gd, Tb, Dy, Ho, Er, Tm, Yb, Lu oder Y darstellt,
x größer als 0,1 und kleiner als 10 ist,
y größer als 0 und kleiner oder gleich 10 ist,
z größer als 0 und kleiner oder gleich 10 ist,
y+z größer als 0,1 und kleiner als 20 ist,
u größer als 0,5 und kleiner als 20 ist und
v größer ist als x+y+z+u und kleiner als 5+x+y+z+u, welches das Vermischen der Verbindungen der Elemente M, Tl, Sr, Ca und Cu und, falls nötig, Erhitzen umfaßt.

2. Verfahren nach Anspruch 1, wobei die Verbindungen sind:
a) ein Oxid von M,
b) ein Oxid von Tl,
c) ein Oxid oder Carbonat von Sr,
d) ein Oxid oder Carbonat von Ca und
e) ein Oxid von Cu.

3. Verfahren nach Anspruch 1 oder 2, wobei die Verbindungen in solchen Mengen gemischt werden, daß das Molverhältnis M:Tl:Sr:Ca:Cu entweder ungefähr 1:2:2:2:3 oder 1:1:2:4:5 beträgt.

4. Verfahren nach einem der Ansprüche 1 bis 3, welches umfaßt:
1) Vermischen der Verbindungen (c), (d) und (e),
2) Erhitzen der Mischung,
3) Mischen der so entstandenen Verbindung mit (a) und gegebenenfalls (b),
4) Erhitzen der Mischung und,
5) falls nötig, das Zusammenbringen der Mischung mit (b) und Erhitzen.

5. Verfahren nach einem der Ansprüche 1 bis 4, wobei M das Element Pr oder Tb darstellt.

6. Verfahren nach Anspruch 4 oder 5, wobei in Schritt (2) mindestens 24 Stunden lang auf 900 bis 1000°C in Luft erhitzt wird.

7. Verfahren nach einem der Ansprüche 4 bis 6, wobei die nach Schritt (2) entstandene Verbindung die allgemeine Formel Sr₂Ca₂Cu₃O₇ oder Sr₂Ca₄Cu₅O₁₁ aufweist.

8. Verfahren nach einem der Ansprüche 4 bis 7, wobei in Schritt (1) die Verbindungen in einem Molverhältnis (c):(d):(e) von entweder ungefähr 2:2:3 oder ungefähr 2:4:5 gemischt werden.

9. Verfahren nach einem der Ansprüche 4 bis 8, wobei in Schritt (4) auf 850 bis 1000°C im Sauerstoffstrom erhitzt wird.

## Revendications (Revendications pour l'(les) Etat(s) contractant(s) suivant(s): AT, BE, CH, DE, FR, GB, GR, IT, LI, LU, NL, SE)

1. Composé ayant la formule générale :
MTlₓSr_{y}Ca_{z}CuᵤOᵥ
dans laquelle :
- M représente La, Pr, Nd, Sm, Eu, Gd, Tb, Dy, Ho, Er, Tm, Yb, Lu ou Y ;
- x est supérieur à 0,1 et inférieur à 10 ;
- y est supérieur à zéro et inférieur ou égal à 10 ;
- z est supérieur à zéro et inférieur ou égal à 10 ;
- y + z est supérieur à 0,1 et inférieur à 20 ;
- u est supérieur à 0,5 et inférieur à 20 ; et
- v est supérieur à x + y + z + u et inférieur à 5 + x + y + z + u.

2. Composé selon la revendication 1, dans lequel M représente Pr ou Tb.

3. Procédé de préparation d'un composé de la formule générale :
MTlₓSr_{y}Ca_{z}CuᵤOᵥ
dans laquelle :
- M représente un élément des terres rares ;
- x, y, z, u et v sont tels que définis à la revendication 1,
le procédé comprenant le mélange de composés des éléments M, Tl, Sr, Ca et Cu et un chauffage si nécessaire.

4. Procédé selon la revendication 3, dans lequel les composés sont :
(a) un oxyde de M ;
(b) un oxyde de Tl ;
(c) un oxyde ou carbonate de Sr ;
(d) un oxyde ou carbonate de Ca ; et
(e) un oxyde de Cu.

5. Procédé selon la revendication 3 ou 4, dans lequel les composés sont mélangés dans des quantités telles que le rapport molaire M:Tl:Sr:Ca:Cu est, ou bien environ 1:2:2:2:3, ou bien environ 1:1:2:4:5.

6. Procédé selon l'une des revendications 3 à 5, comprenant :
(1) le mélange des composés (c), (d) et (e) ;
(2) le chauffage du mélange ;
(3) le mélange du composé résultant avec (a) et facultativement (b) ;
(4) le chauffage du mélange ; et
(5) si nécessaire, la mise en contact du mélange avec (b) et un chauffage.

7. Procédé selon l'une des revendications 3 à 6, dans lequel M représente Pr ou Tb.

## Revendications (Revendications pour l'(les) Etat(s) contractant(s) suivant(s): ES)

1. Procédé de préparation d'un composé de formule générale :
MTlₓSr_{y}Ca_{z}CuᵤOᵥ
dans laquelle :
- M représente La, Pr, Nd, Sm, Eu, Gd, Tb, Dy, Ho, Er, Tm, Yb, Lu ou Y ;
- x est supérieur à 0,1 et inférieur à 10 ;
- y est supérieur à zéro et inférieur ou égal à 10 ;
- z est supérieur à zéro et inférieur ou égal à 10 ;
- y + z est supérieur à 0,1 et inférieur à 20 ;
- u est supérieur à 0,5 et inférieur à 20 ; et
- v est supérieur à x + y + z + u et inférieur à 5 + x + y + z + u ;
le procédé comprenant le mélange de composés des éléments M, Tl, Sr, Ca et Cu et un chauffage si nécessaire.

2. Procédé selon la revendication 1, dans lequel les composés sont :
(a) un oxyde de M ;
(b) un oxyde de Tl ;
(c) un oxyde ou carbonate de Sr ;
(d) un oxyde ou carbonate de Ca ; et
(e) un oxyde de Cu.

3. Procédé selon la revendication 1 ou 2, dans lequel les composés sont mélangés dans des quantités telles que le rapport molaire M:Tl:Sr:Ca:Cu est, ou bien environ 1:2:2:2:3, ou bien environ 1:1:2:4:5.

4. Procédé selon l'une des revendications 1 à 3 comprenant :
(1) le mélange des composés (c), (d) et (e) ;
(2) le chauffage du mélange ;
(3) le mélange du composé résultant avec (a) et facultativement (b) ;
(4) le chauffage du mélange ; et
(5) si nécessaire, la mise en contact du mélange avec (b) et un chauffage.

5. Procédé selon l'une des revendications 1 à 4, dans lequel M représente Pr ou Tb.

6. Procédé selon la revendication 4 ou 5, dans lequel, en (2), le chauffage est conduit à une température de 900 - 1000°C, dans l'air, pendant au moins 24 heures.

7. Procédé selon l'une des revendications 4 à 6, dans lequel, après (2), le composé résultant est de formule générale Sr₂Ca₂Cu₃O₇ ou Sr₂Ca₄Cu₅O₁₁.

8. Procédé selon l'une des revendications 4 à 7 dans lequel, en (1), les composés sont mélangés dans le rapport molaire (c):(d):(e) ou bien d'environ 2:2:3 ou bien d'environ 2:4:5.

9. Procédé selon l'une des revendications 4 à 8, dans lequel, en (4), le chauffage est conduit à une température de 850 - 1000°C, dans un courant d'oxygène.
